# EUROPEAN PATENT SPECIFICATION

(11) **EP 0 468 062 B1**
(45) Date of publication and mention of the grant of the patent: **05.11.1997**
(21) Application number: 90113086.4
(22) Date of filing: 09.07.1990
(51) Int. Cl.: A47K 5/12, H03K 17/94

(54) **Electronically controlled fluid dispenser**
Elektronisch betätigbare Flüssigkeitsspender
Distributeur de fluides contrôlé électroniquement

(43) Date of publication of application: 29.01.1992
(73) Proprietor: CAREX INC., Brookline, Massachusetts 02146 (US)
(72) Inventor: Celeste, Salvatore A., Peabody, Massachusetts 01960 (US)
(74) Representative: Kinzebach, Werner, Dr.

(56) References cited:
- EP-A- 78 181
- EP-A- 0 341 757
- DE-A- 3 229 360
- DE-A- 3 531 385

## Description

This invention relates to electronically-controlled fluid dispensers, particularly for dispensing soap for clinical application, and more particularly to an electronically-controlled fluid dispenser which is aseptic in operation, self-venting and responsive to an infrared reflected signal of predetermined configuration.

Mechanical fluid dispensers require the user to actuate the pumping mechanism by hand or foot. Operation by hand is not considered very sanitary and is undesirable for use in medical and dental facilities. The foot-actuated fluid dispenser is an unwieldly assembly which is cumbersome to use, bulky and expensive. Accordingly, a need exists for an inexpensive, compact and relatively small electronically-controlled fluid dispenser for universal clinical application in medical and dental facilities, as well as industrial and commercial institutions.

Electronically-controlled fluid dispensers are not new and to a limited degree are presently commercially available. The commercially available dispenser is an elaborate fluid pumping system containing a pump specifically designed for this purpose and a solenoid-controlled electromechanical assembly for operating the pump in response to an optically-detected signal. A solenoid consumes a substantial amount of power and accordingly must be powered by alternating current from a source of conventional AC power. The solenoid is actuated by a photodetection arrangement involving the interruption of a beam of light or the detection of irradiated energy within a prescribed bandwidth. The latter mechanism of photodetection is very susceptible to extraneous light. To avoid false operation, the detection system is sensitized to the reflected signal simply by requiring the user or the user's hands to be positioned very close to the light source to function. Also, the pumping sequence and mode of operation requires considerable electrical power to discharge the desired dosage of fluid. Accordingly, such dispensers are, by their nature, large, bulky units which are far more costly than their mechanical counterparts.

From DE-A-35 31 385 a fluid dispenser according to the preamble of present claim 1 is known. EP-A-0 078 181 describes a fluid dispenser comprising an optical control mechanism based on the detection of reflected infrared light pulses.

The problem to be solved by the present invention is to provide a more reliable and less power consuming, battery operatable fluid dispenser.

This problem is solved by the fluid dispenser as disclosed in present claim 1.

Further preferred embodiments of the dispenser according to the present invention are subject of the dependent claims.

The electronic dispenser of the present invention has been designed to operate at very low power, either from a battery with very little power drain or from a conventional AC source of power. The system utilizes a rotary motor integrated in an assembly with a self-priming, self-venting pump and a conventional container for storing the fluid to be dispensed. The motor is controllably actuated by an electronic control circuit which uses a photodetection circuit designed to respond only to a reflected infrared signal of predetermined configuration. By integrating a motor drive with a conventional, mechanically-operated, self-priming pump, the system cost is reduced to a fraction of the cost of the commercially available electronically-controlled fluid dispensers. In addition, by generating a light pulse of predetermined waveshape, controlled detection is simplified without concern of extraneous light. The simplicity of the system is its unique attribute.

In the following, a preferred embodiment of the present invention is described with reference to the attached drawings.
Figure 1 is a front elevation of the electronically-controlled fluid dispensing system of the present invention;
Figure 2 is a side elevation of the fluid dispenser of Figure 1, adapted for mounting on a wall;
Figure 3 is a front elevation, similar to Figure 1, with the cover of the dispenser removed;
Figure 4 is a cross-sectional view of Figure 3, taken along the lines 4-4 of Figure 3;
Figure 5 is another cross-sectional view of Figure 3, taken along the lines 5-5 of Figure 3;
Figure 6 is a partial view in cross section of an alternate embodiment of the invention;
Figure 7 is a block diagram of the system operation for the fluid dispenser of Figure 1;
Figure 8 is the preferred waveshape for the transmitted energy pulse from the photo-emitter of Figure 7; and
Figure 9 is the electrical schematic for the block diagram of Figure 7.

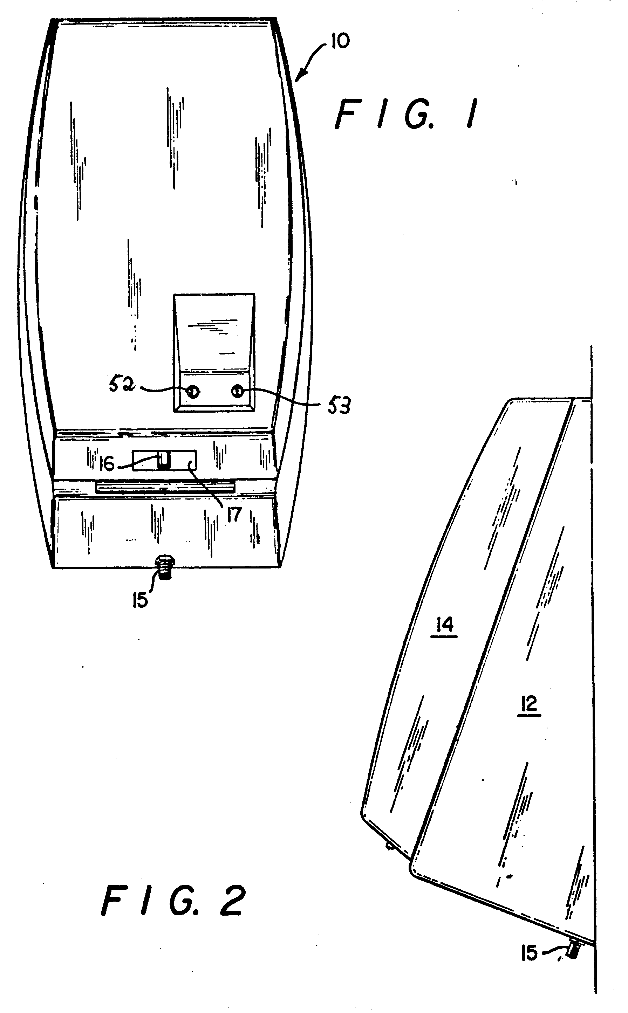

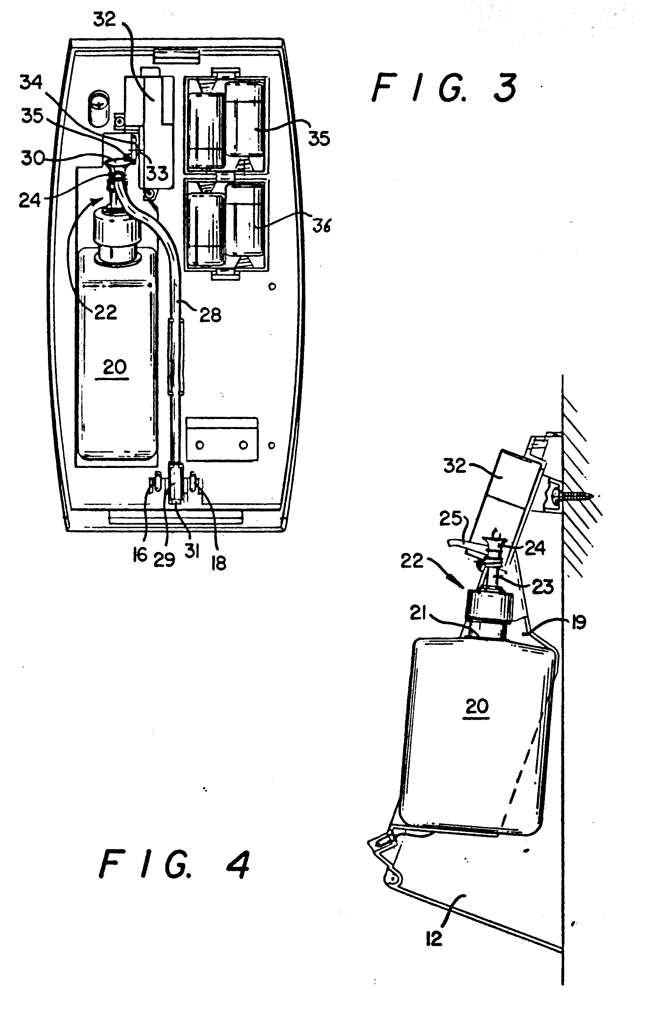

The fluid dispenser of the present invention, is identified by the reference number "10" and, as is shown in Figures 1 and 2, is a relatively small, lightweight, self-contained unit having a body (12) adapted for wall-mounting and a removable cover (14) hinged to the body (12). The fluid dispenser (10) may be connected through an electrical connector (15) to a conventional AC source of power. An infrared light emitting diode (LED) (16), as shown in Figures 3-5, extends through a slot (17) in the cover (14) for transmitting a pulse of infrared energy at predetermined time intervals, as will hereinafter be explained at greater length. A corresponding photoreceiver (18) is mounted in the slot (17) alongside the photo-emitter (16).

A fluid container (20) is removably mounted in a compartment (19) in the body (12) of the dispenser (10). The container (20) may be filled with any desired fluid medium to be discharged through the dispenser, preferably a disinfecting soap. The container (20) is mounted with the top end (21) standing upright in the body (12). A conventional, self-priming pump (22) is affixed to the top end (21) of the container (20). The pump (22) is of conventional design, having a plunger (23) extending from a vented pump head (24), through an internal check valve (not shown). The pump is actuated by depressing the pump head (24) which depresses the plunger (23) for discharging fluid from the container (20) through the spout (25) extending from the pump head (24). The volume of fluid discharged from the pump (22) on the downstroke cycle is replenished with a corresponding volume of air sucked into the container (20) through the internal pump check valve (not shown) in the vented pump head (24). The pump head (24) is spring-loaded so that the head (24) returns to its normal undepressed or primed position when it is released. The container (20) is preferably a flexible plastic bottle which may expand and contract to assist the pumping action. The pump (22) is a conventional positive displacement pump with an internal ball check valve to permit venting through the pump head (24) from the immediate atmosphere surrounding the container (20) internal of the body (12) of the fluid dispenser (10).

The spout (25) is connected through tubing (28) which passes through a conventional one-way check valve (29) located at the discharge end (31) of the tubing (28). Fluid may be discharged through the check valve (29) in only one direction. Accordingly, the check valve (29) prevents the reverse flow of fluid through the tubing (28) on the upstroke of the plunger (23). The check valve (29) operates in concert with the self-priming pump (22) to prevent contamination of the container (20) which cannot be compromised by conditions external of the dispenser (10). This assures aseptic operation. The one-way check valve (29) is conveniently mounted between the photo-emitter (16) and photoreceiver (18) to partition each from the other. However, an alternative arrangement is to insert the photo-emitter (16) and photodetector (18) in separate cylindrical tubes which isolates them. In this way, the only way light may be detected is by a reflected signal passing through the tube surrounding the photodetector (18).

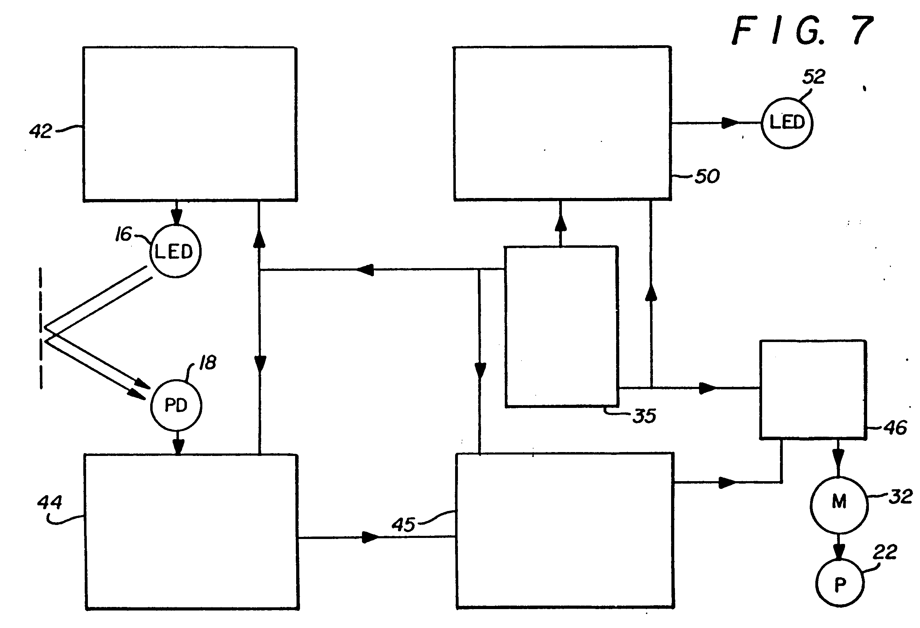

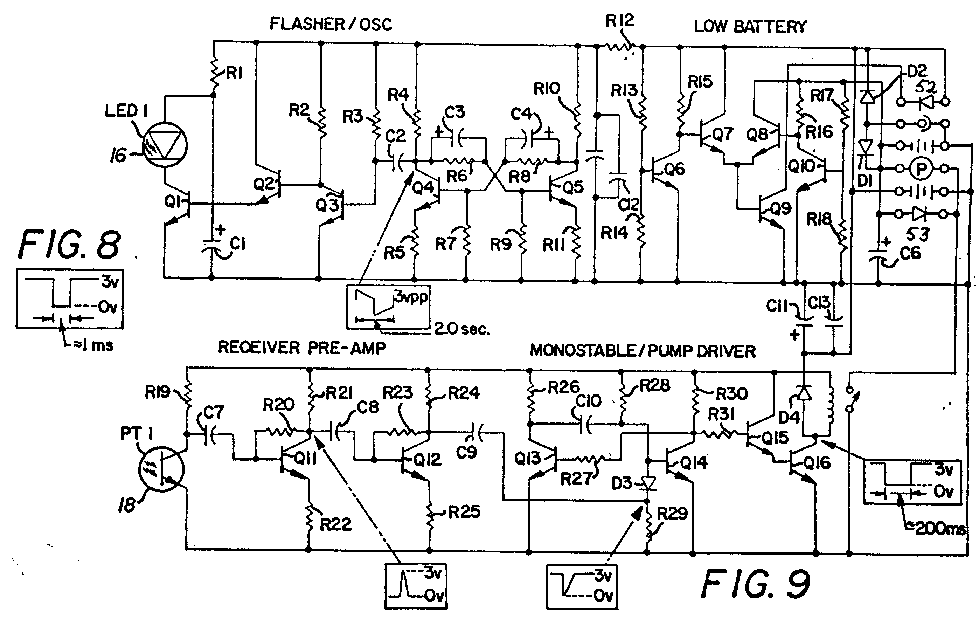

The pump head (24) has a concave depression (30) giving it a "saddle-like" geometry. The container (20) and pump (22) may preferably represent a commercially available mechanically-operated fluid dispenser. This minimizes manufacturing cost and permits the use of interchangeable dispensers. It also preserves sanitary operation of the container (20) in that the pump (22) and container (20) may be readily replaced as one unit. In accordance with the present invention, the pump head (24) is driven electromechanically under the control of an electronic infrared control and sensor circuit, as illustrated in Figures 7 and 9.

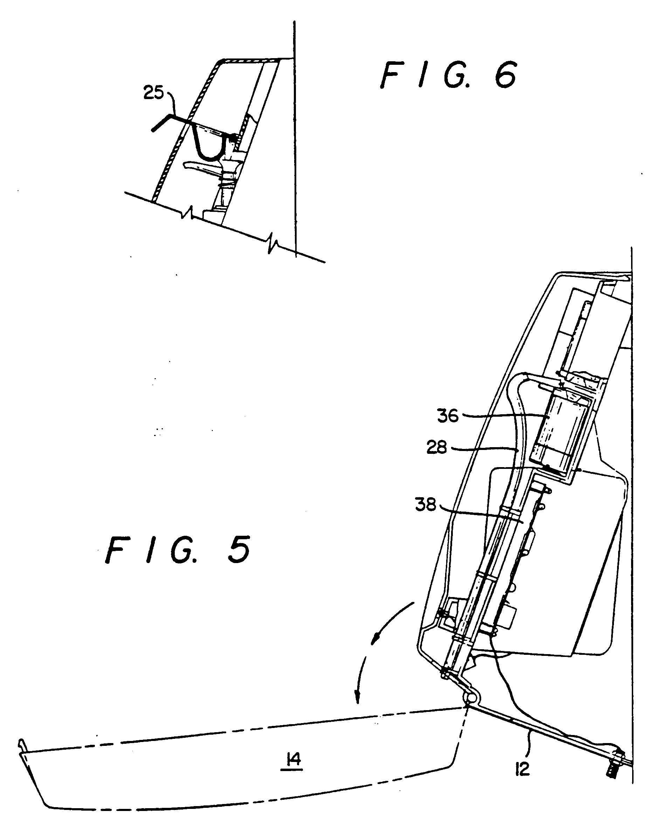

A rotary motor (32) preferably a DC motor, is mounted in the body (12) of the fluid dispenser (10). The rotary motor (32) has a rotatable shaft (33) which has an eccentric cam (34) affixed thereto. The eccentric cam (34) is positioned with the cam shaft (35) in direct contact with the pump head (24), and preferably resting on the "saddle-like" concave surface (30). As the shaft (33) rotates, the cam shaft (35) rides on the concave surface (30), providing automatically-controlled linear reciprocating movement of the pump head (24) which, in essence, simulates mechanical depression of the pump head (24). The rotary motor (32) is operated from batteries (35) under the control of the electronic infrared control and sensor circuit of Figures 7 and 9. Figure 6 is an alternate embodiment or accessory for mechanically depressing the pump head (24) through the lever (25).

The electronic control circuity for the fluid dispenser (10) is mounted on a circuit board (38) removably inserted into the body (12) of the dispenser (10). A short burst or pulse of infrared energy is generated from the photo-emitter (16) by the driver circuit (42). The driver circuit (42) causes the pulse of energy to be of a predetermined waveshape, as shown in Figure 8, having a fast rise time. Power is supplied to the photo-emitter (16) and driver circuit (42) by a battery (36). The photodetector (18) is selectively responsive to the infrared pulse generated by the emitter (16) and through a receiver circuit (44) is simultaneously responsive to the waveshape configuration of the infrared pulse for actuating the motor pump driving circuit (45). The motor pump driving circuit (45) generates a timed signal which actuates a relay circuit (45) which, in turn, controls the supply of power to the rotary motor (32).

The rotary motor (32) is operated for a controlled time period corresponding to the duration of the timed signal generated by the motor pump driving circuit (44). The motor (32) operates the pump (22) as heretofore explained. Power to the motor (32) is applied from a battery source (35) or from an AC source of power (not shown). A low battery circuit (50) operates a low battery LED (52) and an LED dispenser light (53). Actuation of LED (52) provides a visible indication for replacing the control batteries (36) when they have been substantially fully discharged. An LED dispenser light (53) is actuated during the time interval the motor (32) is operational, which provides a visual indication of satisfactory electronic performance and as an indicator of the supply of soap in the container (20).

The preferred circuitry for the block diagram of Figure 7 is shown in Figure 9. The LED emitter (16) is connected in the driver circuit (42) which consists of transistors Q1, Q2, and Q3, respectively. The driver circuit (42) is, in turn, driven by an oscillator (43) consisting of an astable multivibrator formed from transistors Q4 and Q5, in combination with resistors R4 through R11, and capacitors C3 and C4. The oscillator (43) has a frequency of 0.5 Hz and is coupled through capacitor C2 to the driver circuit (42) This causes the emitter (16) to pulse (flash) once every few seconds. The pulse width is designed to be approximately 1 millisecond, with a sharp (very fast rise time) leading edge. The duty cycle for the operation of the emitter (16) is held to a small percentage, preferably only one percent (1%). Accordingly, very little power is consumed in providing the generated light pulses.

The infrared detector (18) is connected to the receiving circuit (44) which consists of transistor Q11, which operates only in response to a detected pulse with a fast rise time leading edge. A properly detected pulse causes a sufficient increase in photocurrent through the detector (18) drawn from the base of transistor Q11, which causes transistor Q11 to momentarily turn off. This produces a pulse at collector of transistor Q11 which is amplified by transistor Q12 and fed via capacitor C9 into the pump driving circuit (45). The pump driving circuit (45) consists of a monostable multivibrator circuit formed from transistors Q13 and Q14 and resistors R26 through R30. When the pump driving circuit (45) is triggered, it produces a timing pulse of predetermined duration. The timing pulse energizes the relay (46) to close the relay contacts for supplying power from the batter (35) to operate the motor (32). The motor (32) is operated for a time period corresponding to the duration of the timing pulse.

The low battery circuit (50) consists of resistors R13 and R14 and transistors Q6, Q7, Q8, Q9 and Q10. Resistors R13 and R14 form a voltage divider circuit to monitor the voltage of the control battery (36). When the voltage of battery (36) drops to approximately 2.5 volts, the drop across resistor R14 is insufficient to forward bias the base-emitter junction of transistor Q6. This causes transistor Q6 to turn off, which causes its connector junction to rise to battery voltage, turning on transistor Q9 via transistor Q7. Transistor Q9, when turned on, causes LED (52) to actuate, indicating a low-battery condition for battery (36). An identical circuit operation is provided for the pump battery (35) consisting of resistors R17 and R18, which form a voltage divider network and resistor R16 in conjunction with transistor Q10 and Q8.

## Claims

1. An electronically-controlled fluid dispensing system comprising a housing (12), a container (20) mounted with the top end (21) standing upright in said housing (12) for storing fluid to be dispensed from said housing (12), a dispensing head (24) with a spout (25) connected to said container (20) at said top end (21) and being linearly movable, whereby fluid can be discharged from the top end (21) of said container (20) through said spout (25) upon depression of said dispensing head (24), a rotary motor (32) mounted in said housing (12) and having a rotatable output drive shaft (33), a cam (34) being eccentrically mounted upon said output drive shaft (33), and an electrical control drive circuit for operating said rotary motor (32) upon detection of an optical signal, said drive circuit including means (16, 42) for emitting an optical signal, optical detection means (18, 44) responsive to said optical signal, means (45) responsive to actuation of said optical detection means (18, 44) for generating a control signal, and means (46) for applying power to said rotary motor (32) in response to said control signal,
**characterized in that**
said cam (34) is provided with a cam shaft (35) being juxtaposed in physical contact against said movable dispensing head (24), said control signal is a timed signal operating said rotary motor over a short, predetermined time interval; and
said drive circuit emits said optical signal external of said housing, said optical signal being a pulse of short duration emitted once every few seconds and having a predetermined waveshape and a predetermined wavelength in the infrared spectrum with a predetermined configuration, and in that said optical detector means are responsive to the predetermined configuration and waveshape of said optical signal in the infrared spectrum being reflected back into said housing.

2. An electronically-controlled fluid dispensing system as defined in claim 1 further characterized in that said container (20) is flexible.

3. An electronically-controlled fluid dispensing system as defined in claim 1 or 2, wherein said movable dispensing head (24) comprises a self-priming pump (22) removably mounted in said housing (12) in combination with said container (20).

4. An electronically controlled fluid dispensing system as defined in claim 3, wherein said self-priming pump (22) includes a plunger (23) responsive to said dispensing head (24) and a compression spring for restoring the plunger to its normal position upon release of said dispensing head.

5. An electronically-controlled fluid dispensing system as defined in claim 3, wherein said dispenser is powered from a plurality of batteries or from a source of conventional AC power.

6. An electronically-controlled fluid dispensing system as defined in claim 5 further comprising a tube (28) connected to said spout (25), with said tube having an open discharge end and a one-way check valve (29) connected to said open discharge end of said tube (28) to permit unidirectional discharge of fluid from said dispenser.

7. An electronically-controlled fluid dispensing system as defined in one of claims 1 - 6, wherein said emitted optical signal has a fast rise time of short duration.

8. An electronically-controlled fluid dispensing system as defined in claim 7, wherein said drive circuit generates an optical signal with a very low duty cycle.

9. An electronically-controlled fluid dispensing system as defined in claim 8, wherein the duty cycle is one percent.

10. An electronically-controlled fluid dispensing system as defined in one of claims 7 - 9, wherein said optical detector means (18,44) are responsive to the presence of said optical signal having a fast rise time leading edge.

11. An electronically-controlled fluid dispensing system as defined in one of claims 8 - 10, wherein said means (46) for applying power to said rotary motor is a relay circuit.

## Patentansprüche

1. Elektronisch gesteuertes Fluidabgabesystem, umfassend ein Gehäuse (12), einen Behälter (20) zum Aufbewahren von aus dem Gehäuse (12) abzugebendem Fluid, welcher mit dem oberen Ende (21) aufrecht in dem Gehäuse (12) angebracht ist, einen an dem oberen Ende (21) mit dem Behälter (20) verbundenen und linear beweglichen Abgabekopf (24) mit einem Abflußelement (25), wobei Fluid beim Hinunterdrücken des Abgabekopfes (24) von dem oberen Ende (21) des Behälters (20) durch das Abflußelement (25) abgegeben werden kann, einen in dem Gehäuse (12) montierten Drehmotor (32), der eine drehbare Antriebswelle (33) aufweist, eine exzentrisch auf der Antriebswelle (33) montierte Nocke (34), und eine elektrische Antriebssteuerschaltung zum Betreiben des Drehmotors (32) bei Detektion eines optischen Signals, wobei die Antriebsschaltung Mittel (16,42) zum Aussenden eines optischen Signals, auf das optische Signal reagierende optische Detektionsmittel (18,44), auf die Betätigung der optischen Detektionsmittel (18,44) reagierende Mittel (45) zur Erzeugung eines Steuersignals und Mittel (46), die den Drehmotor (32) als Reaktion auf das Steuersignal mit Strom versorgen, aufweist
**dadurch gekennzeichnet,**
daß die Nocke (34) einen Nockenfinger (35) aufweist, der sich in unmittelbarem physischen Kontakt mit dem beweglichen Abgabekopf (24) befindet, wobei das Steuersignal ein zeitlich abgestimmtes Signal ist, das den Drehmotor während eines bestimmten kurzen Zeitintervalls betreibt; und
daß die Antriebsschaltung das optische Signal außerhalb des Gehäuses aussendet, wobei das optische Signal ein kurzzeitiger Impuls ist, der jeweils einmal innerhalb einiger Sekunden ausgesandt wird und eine bestimmte Wellenform, sowie eine bestimmte konfigurierte Wellenlänge im infraroten Spektrum besitzt, und
daß die optischen Detektionsmittel auf die bestimmte Konfiguration und Wellenlänge des optischen Signals im Infrarotspektrum reagieren, welches zurück in das Gehäuse reflektiert wird.

2. Elektronisch gesteuertes Fluidabgabesystem gemäß Anspruch 1, dadurch gekennzeichnet, daß der Behälter (20) flexibel ist.

3. Elektronisch gesteuertes Fluidabgabesystem gemäß Anspruch 1 oder 2, wobei der bewegliche Abgabekopf (24) eine selbstansaugende Pumpe (22) umfaßt, die kombiniert mit dem Behälter (20), abnehmbar in dem Gehäuse (12) angebracht ist.

4. Elektronisch gesteuertes Fluidabgabesystem gemäß Anspruch 3, wobei die selbstansaugende Pumpe (22) einen von dem Abgabekopf (24) betätigten Tauchkolben (23) und eine Kompressionsfeder aufweist, um den Tauchkolben nach Freigabe des Abgabekopfes in seine Ruheposition zurückzuführen.

5. Elektronisch gesteuertes Fluidabgabesystem gemäß Anspruch 3, wobei die Abgabeeinrichtung durch mehrere Batterien oder durch eine herkömmliche Wechselstromquelle mit Strom versorgt wird.

6. Elektronisch gesteuertes Fluidabgabesystem gemäß Anspruch 5, das außerdem einen mit dem Abflußelement (25) verbundenen Schlauch (28) umfaßt, wobei der Schlauch ein offenes Abflußende und ein Rückschlagventil (29) aufweist, das mit dem offenen Abflußende des Schlauchs (28) verbunden ist und die unidirektionale Abgabe von Fluid aus der Abgabeeinrichtung ermöglicht.

7. Elektronisch gesteuertes Fluidabgabesystem gemäß einem der Ansprüche 1-6, wobei das ausgesandte optische Signal eine schnelle, kurze Anstiegszeit aufweist.

8. Elektronisch gesteuertes Fluidabgabesystem gemäß Anspruch 7, wobei die Antriebsschaltung ein optisches Signal mit einem sehr niedrigem Arbeitszyklus erzeugt.

9. Elektronisch gesteuertes Fluidabgabesystem gemäß Anspruch 8, wobei der Arbeitszyklus 1 % beträgt.

10. Elektronisch gesteuertes Fluidabgabesystem gemäß einem der Ansprüche 7-9, wobei die optischen Detektionsmittel (18,44) auf ein vorhandenes optisches Signal reagieren, dessen führende Kante eine schnelle Anstiegszeit aufweist.

11. Elektronisch gesteuertes Fluidabgabesystem gemäß einem der Ansprüche 8-10, wobei die Mittel (46) um den Drehmotor mit Strom zu versorgen, ein Relaisschaltkreis sind.

## Revendications

1. Système distributeur de fluide contrôlé électroniquement comprenant un boîtier (12), un conteneur (20) monté avec l'extrémité supérieure (21) placée verticalement dans ledit boîtier (12), pour stocker un fluide à distribuer provenant dudit boîtier (12), une tête de distribution (24) avec un bec (25) connecté audit conteneur (20) à ladite extrémité supérieure (21), et linéairement mobile, de façon que le fluide puisse être déchargé de l'extrémité supérieure (21) dudit conteneur (20) par ledit bec (25) lors de l'enfoncement de ladite tête de distribution (24), un moteur rotatif (32) monté dans ledit boitier (12), et ayant un arbre de commande de sortie rotatif (33), une came (34) montée de manière excentrée sur ledit arbre de commande de sortie (33) et un circuit de commande à contrôle électrique destiné à actionner ledit moteur rotatif (32) lors de la détection d'un signal optique, ledit circuit de commande comportant des moyens (16, 42) pour émettre un signal optique, des moyens de détection optiques (18, 44) sensibles audit signal optique, des moyens (45) sensibles à l'actionnement desdits moyens de détection optiques (18, 44), pour générer un signal de contrôle, et des moyens (46) pour appliquer de l'énergie audit moteur rotatif (32), en réponse audit signal de contrôle,
caractérisé en ce que
ladite came (34) est pourvue d'un arbre à cames (35), juxtaposé en contact physique contre ladite tête de distribution mobile (24), ledit signal de contrôle est un signal synchronisé actionnant ledit moteur rotatif pendant une durée prédéterminée courte ; et
ledit circuit de commande émet ledit signal optique à l'extérieur dudit boîtier, ledit signal optique étant une impulsion de courte durée émise une fois toutes les quelques secondes, et ayant une forme d'onde prédéterminée et une longueur d'onde prédéterminée dans le spectre infrarouge, avec une configuration prédéterminée, et en ce que lesdits moyens de détecteur optique sont sensibles à la configuration et à la forme d'onde prédéterminées dudit signal optique dans le spectre infrarouge réfléchi en retour dans ledit boîtier.

2. Système distributeur de fluide contrôlé électroniquement selon la revendication 1, caractérisé en outre en ce que ledit conteneur (20) est souple.

3. Système distributeur de fluide contrôlé électroniquement selon l'une des revendications 1 ou 2, dans lequel ladite tête de distribution mobile (24) comprend une pompe à amorçage automatique (22) montée de manière amovible dans ledit boîtier (12) en association avec ledit conteneur (20).

4. Système distributeur de fluide contrôlé électroniquement selon la revendication 3, dans lequel ladite pompe à amorçage automatique (22) comprend un piston (23) sensible à ladite tête de distribution (24), et un ressort de compression destiné à ramener le piston à sa position normale après avoir relâché ladite tête de distribution.

5. Système distributeur de fluide contrôlé électroniquement selon la revendication 3, dans lequel ledit distributeur est alimenté par une pluralité de batteries, ou par une source d'alimentation classique en CA.

6. Système distributeur de fluide contrôlé électroniquement selon la revendication 5, comprenant en outre un tube (28) connecté audit bec (25), ledit tube ayant une extrémité de décharge ouverte et une valve de contrôle unidirectionnelle (29) connectée à ladite extrémité de décharge ouverte dudit tube (28), pour permettre une décharge unidirectionnelle du fluide depuis ledit distributeur.

7. Système distributeur de fluide contrôlé électroniquement selon l'une des revendications 1 à 6, dans lequel ledit signal optique émis a un temps de montée rapide de courte durée.

8. Système distributeur de fluide contrôlé électroniquement selon la revendication 7, dans lequel ledit circuit de commande génère un signal optique avec un rapport cyclique très faible.

9. Système distributeur de fluide contrôlé électroniquement selon la revendication 8, dans lequel le rapport cyclique est d'un pour cent.

10. Système distributeur de fluide contrôlé électroniquement selon l'une des revendications 7 à 9, dans lequel lesdits moyens de détecteur optique (18, 44) sont sensibles à la présence dudit signal optique ayant un front de montée à temps de montée rapide.

11. Système distributeur de fluide contrôlé électroniquement selon l'une des revendications 8 à 10, dans lequel lesdits moyens (46) pour appliquer de l'énergie audit moteur rotatif sont constitués par un circuit à relais.
